# EUROPEAN PATENT SPECIFICATION

(11) **EP 2 320 239 B1**
(45) Date of publication and mention of the grant of the patent: **31.07.2013**
(21) Application number: 10188204.1
(22) Date of filing: 20.10.2010
(51) Int. Cl.: G01R 1/04, G01R 31/28

(54) **Substrate for use in measuring electric characteristics**
Substrat zur Verwendung bei der Messung elektrischer Eigenschaften
Substrat pour une utilisation dans la mesure de caractéristiques électriques

(30) Priority: 09.11.2009 JP 2009256093
(43) Date of publication of application: 11.05.2011
(73) Proprietor: Murata Manufacturing Co., Ltd., Nagaokakyo-shi, Kyoto-fu 617-8555 (JP)
(72) Inventor: Yonekura, Hiroshi, Nagaokakyo-shi, Kyoto-fu 617-8555 (JP)
(74) Representative: Thévenet, Jean-Bruno

(56) References cited:
- EP-A2- 2 197 073
- DE-A1- 3 703 030

## Description

### BACKGROUND OF THE INVENTION

### 1. Field of the Invention

The present invention relates to a substrate for use in measuring electric characteristics of an electronic component while mounting the electronic component thereon and being connected to a measurement device during measurement.

### 2. Description of the Related Art

Electric characteristics of electronic components, such as filters and duplexers, may often be measured to determine whether they are within specifications. Electric characteristics of an electronic component can be measured by mounting the electronic component on a substrate for use in measuring electric characteristics and connecting the substrate to a measurement device. One typical example of such a substrate for use in measuring electric characteristics is a configuration in which a component mounting electrode for use in implementing an output terminal of an electronic component thereon and a connector for use in connecting to a measurement device are connected by a coplanar line having specific impedance. Electronic components have various sizes and different terminal locations, and it is necessary to prepare a substrate for use in measuring electric characteristics so as to support each of various types of electronic components.

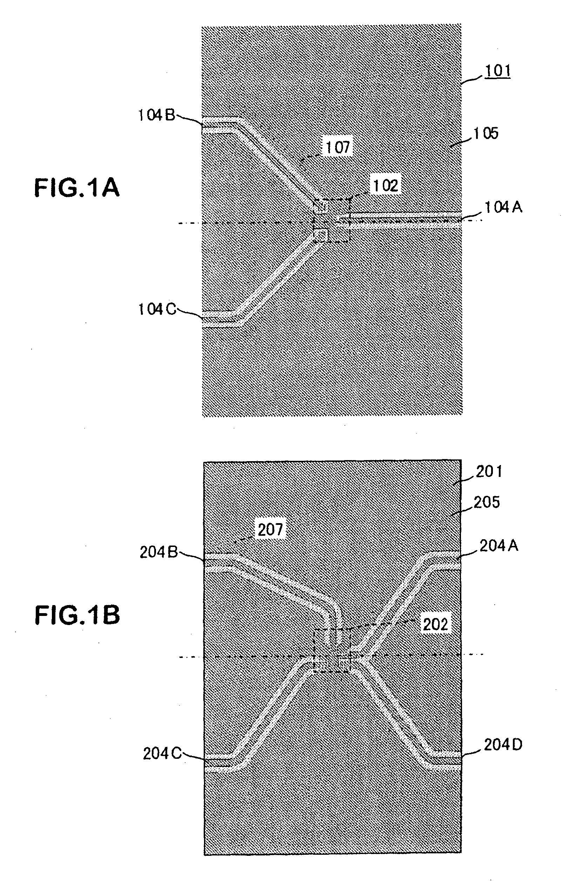

Fig. 1A is a plan view of a first configuration example of a substrate for use in measuring electric characteristics. A substrate 101 for use in measuring electric characteristics includes coplanar lines 104A to 104C, a front-surface earth electrode 105, a back-surface earth electrode (not illustrated), and via electrodes 107. The coplanar line 104A has a first end that is to be connected to an electronic component and that is arranged in a substantially central section of the front or the substrate and a end that is to be connected to a connector for use in to a measurement device and that extends to a right side of the substrate illustrated in the drawing. The coplanar line 104B has a first end arranged in the substantially central section of the front surface of the substrate and a second end extending to a left side of the substrate illustrated in the drawing. The coplanar line 104C has a first end arranged in the substantially central section of the front surface of the substrate and a second end extending to the left side of the substrate. The first ends of the coplanar lines 104A to 104C function as a component mounting electrode 102 to be connected to an output terminal of an electronic component. The front-surface earth electrode 105 extends over substantially the entire front surface of the substrate and is separated from the coplanar lines 104A to 104C. The back-surface earth electrode (not illustrated) extends over substantially the entire back surface of the substrate. The via electrodes 107 extend along the coplanar lines 104A to 104C and provide continuity between the front-surface earth electrode 105 and the back-surface earth electrode (not illustrated). The substrate 101 for use in measuring electric characteristics is employed in a 3-port electronic component having terminals being substantially symmetric about a line.

Fig. 1B is a plan view of a second configuration example of the substrate for use in measuring electric characteristics. A substrate 201 for use in measuring electric characteristics includes coplanar lines 204A to 204D, a front-surface earth electrode 205, a back-surface earth electrode (not illustrated), and via electrodes 207. The coplanar line 204A has a first end arranged in a substantially central section of the front surface of the substrate and a second end extending to a right side of the substrate illustrated in the drawing. The coplanar line 204B has a first end arranged in the substantially central section of the front surface of the substrate and a second end extending to a left side of the substrate illustrated in the drawing. The coplanar line 204C has a first end arranged in the substantially central section of the front surface of the substrate and a second end extending to the left side of the substrate, The coplanar line 204D has a first end arranged in the substantially central section of the front surface of the any a second end extending to the right side of the substrate. The first ends of the microstrip lines 204A to 204D function as a component mounting electrode 202 to be connected to an output terminal of an electronic component. The substrate 201 for use in measuring electric characteristics is employed in a 4-port electronic component having terminals being asymmetric about a line.

For electronic components, such as filters and duplexers, the provision of a plurality of types having terminals positioned as mirror images may be required. The substrate 101 for use in measuring electric characteristics illustrated in Fig. 1A is employed in a plurality of types of electronic components having terminals being substantially symmetric about a line. In contrast, because being employed in an electronic component having terminals being asymmetric about a line, the substrate 201 for use in measuring electric characteristics illustrated in Fig. 1B cannot be used in measuring electric characteristics of another electronic component having terminals positioned as mirror images of those in that electronic component. Therefore, to measure electric characteristics of each of such two electronic components, it is necessary to generate a substrate for measuring characteristics dedicated to each of them. This results in an increased cost of production of substrates for use in measuring electric characteristics and an increased number of items of inventory control.

DE 37 03 030 describes a multi-layer test substrate for use in measuring the electrical characteristics of ICs. This test substrate has conductors and terminals on its upper and lower surfaces but a region for receiving the IC to be tested is provided only on the upper surface.

### SUMMARY OF THE INVENTION

Accordingly, it is an object of the present invention to provide a substrate for use in measuring electric characteristics that is capable of measuring electric characteristics of two electronic components having terminals being asymmetric about a line and being positioned as mirror images.

According to preferred embodiments of the present invention, a substrate for use in measuring electric characteristics includes a plurality of dielectric layers laminated therein; a front-surface component mounting electrode disposed at a front surface of the substrate and allowing a first electronic component to be implemented thereon, the front-surface component mounting electrode comprising a plurality of connections for connecting to terminals of said first electronic component; and first connecting lines electrically connected at one end thereof to said front-surface component mounting electrode and configured for connection at the other end thereof to a measuring device; characterized in that the substrate further comprises: a back-surface component mounting electrode disposed at a back surface of the substrate and allowing a second electronic component to be implemented thereon, the back-surface component mounting electrode comprising a plurality of connections for connecting to terminals of said second electronic component; and second connecting lines electrically connected at one end thereof to said back-surface component mounting electrode and configured for connection at the other end thereof to a measuring device; wherein the front-surface component mounting electrode and the back-surface component mounting electrode exhibit a substantially same pattern when viewed from a direction of a normal to the front surface of the substrate, the layout of the connections of the front-surface component mounting electrode is asymmetric with respect to a line in the plane of the front surface and extending across the front surface substantially centrally thereof, and the layout of the connections of the back-surface component mounting electrode is asymmetric with respect to a line in the plane of the back surface and extending across the back surface substantially centrally thereof.

With this configuration, in measurement of electric characteristics of two electronic components having asymmetric terminals positioned as mirror images, one electronic component can be implemented on the front surface of the substrate and the other electronic component can be implemented on the back surface of the substrate. That is, electric characteristics of two electronic components positioned as mirror images can be measured by a common substrate for use in measuring electric characteristics. Accordingly, electric characteristics of two electronic components can be measured by a single substrate for use in measuring electric characteristics, and a reduced cost of production of substrates and a reduced number of items of inventory control of substrates can be achieved.

The substrate for use in measuring electric characteristics may preferably further include at least one interlayer earth electrode, a plurality of front-surface lines, and a plurality of back-surface lines. The plurality of front-surface lines and the plurality of back-surface lines may preferably exhibit a substantially same pattern when viewed from the direction of the normal to the front surface or the direction of the normal to the back surface. The at least one interlayer earth electrode may preferably be disposed between the dielectric layers of the substrate. The plurality of front-surface lines may preferably be nearer to the front surface of the substrate than to the at least one interlayer earth electrode and be connected to the front-surface component mounting electrode. The plurality of back-surface lines may preferably be nearer to the back surface of the substrate than to the at least one interlayer earth electrode and be connected to the back-surface component mounting electrode.

The at least one interlayer earth electrode in the substrate for use in measuring electric characteristics may preferably include a first interlayer earth electrode facing the plurality of front-surface lines and a second interlayer earth electrode facing the plurality of back-surface lines. The first interlayer earth electrode and the second interlayer earth electrode may preferably be positioned at different interfaces of the dielectric layers.

With this configuration, the front-surface lines and the first interlayer earth electrode form a transmission path, and the back-surface lines and the second interlayer earth electrode form a transmission path. The two transmission paths can be radio-frequency separated by positioning the first interlayer earth electrode and the second interlayer earth electrode in different interfaces of the dielectric layers, and degradation in characteristics of the transmission paths can be reduced.

The substrate for use in measuring electric characteristics may further include another interlayer earth electrode disposed between the dielectric layers between the first interlayer earth electrode and the second interlayer earth electrode.

Another interlayer earth electrode between the two transmission paths can radio-frequency separate the two transmission paths reliably, and degradation in characteristics of the transmission paths can be further reduced.

In the substrate for use in measuring electric characteristics, the plurality of front-surface lines may preferably be disposed at the front surface of the substrate, and the plurality of back-surface lines may preferably be disposed at the back surface of the substrate. The substrate may further include a surface earth electrode disposed beside each of the plurality of front-surface lines and the plurality of back-surface lines and a via electrode that continuity between the surface earth electrode at each of the front surface and the back surface and the at least one interlayer earth electrode.

The provision of a via electrode passing through from the front surface to the back surface can achieve a reduced total number of via electrodes and a reduced cost of production of substrates for use in measuring electric characteristics.

With preferred embodiments of the present invention, because the front-surface component mounting electrode and the back-surface component mounting electrode for use in measuring electric characteristics are disposed so as to exhibit substantially the same pattern when viewed from the direction of the normal to the surface, electric characteristics of two types of electronic components having terminals positioned as mirror images can be measured by a single substrate for use in measuring electric characteristics. Accordingly, a reduced cost of production of substrates and a reduced number of items of inventory control of substrates can be achieved.

Other features, elements, characteristics and advantages of the present invention will become more apparent from the following detailed description of preferred embodiments of the present invention with reference to the attached drawings.

### BRIEF DESCRIPTION OF THE DRAWINGS

Figs. 1A and 1B illustrate configuration examples of a traditional substrate for use in measuring electric characteristics;
Figs. 2A and 2B illustrate a configuration example of a substrate for use in measuring electric characteristics according to a first embodiment of the present invention;
Figs. 3A and 3B are perspective views of the substrate for use in measuring electric characteristics illustrated in Figs. 2A and 2B;
Figs. 4A and 4B illustrate configuration examples of a substrate for use in measuring electric characteristics according to a second embodiment of the present invention;
Figs. 5A and 5B illustrate a configuration example of a substrate for use in measuring electric characteristics according to a third embodiment of the present invention; and
Figs. 6A and 6B illustrate configuration examples of a substrate for use in measuring electric characteristics according to other embodiments of the present invention.

### DESCRIPTION OF THE PREFERRED EMBODIMENTS

A configuration example of a substrate for use in measuring electric characteristics according to a first embodiment of the present invention is described below.

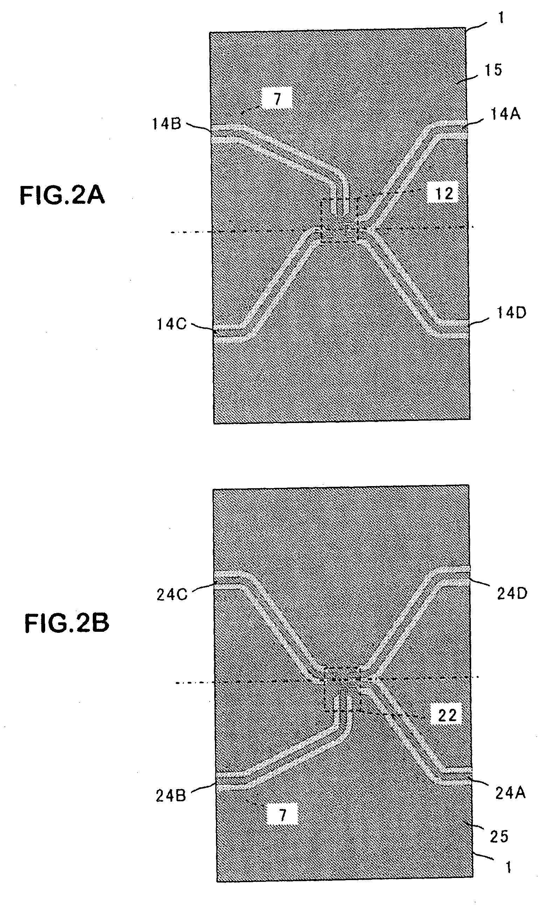

Fig. 2A is a plan view of a front surface of a substrate 1 for use in measuring electric characteristics. Fig. 2B is a plan view of a back surface of the substrate 1 for use in measuring electric characteristics.

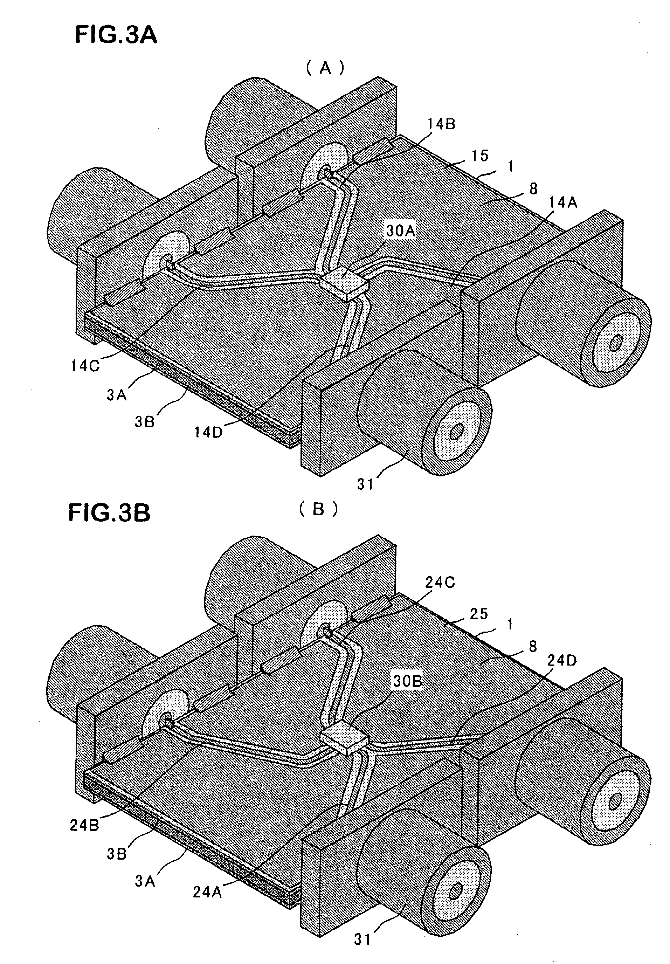

The substrate 1 for use in measuring electric characteristics is a laminated substrate in which three dielectric layers are laminated and includes coplanar lines 14A to 14D and 24A to 24D, a front-surface earth electrode 15, a back-surface earth electrode 25, via electrodes 7, and interlayer earth electrodes 3A and 3B (see Figs. 3A and 3B). The coplanar line 14A has a first end that is to be connected to an electronic component and that is arranged in a substantially central section of a front surface of the substrate and a second end that is to be connected to a connector for use in connecting to a measurement device and that extends to a right side of the substrate illustrated in the drawing. The coplanar line 14B has a first end arranged in the substantially central of the front surface of the substrate and a send extending to a left side of the substrate illustrated in the drawing. The coplanar line 14C has a first end arranged in the substantially central section of the front of the substrate and a second end extending so the left side of the substrate. The coplanar line 14D has a first end arranged in the substantially central section of the front surface of the substrate and a second end extending to the right side of the substrate. The coplanar lines 14A to 14D correspond to front-surface lines according to preferred embodiments of the present invention, and their first ends function as a front-surface component mounting electrode 12 to be connected to an output terminal of an electronic component.

The coplanar line 24A has a first end arranged in a substantially central section of the back surface of the substrate and a second end extending a right side of the substrate illustrated in the drawing. The coplanar line 24B has a first end arranged in the substantially central section of the back surface and a second end extending to a left side of the substrate illustrated in the drawing. The coplanar line 24C has a first end arranged in the substantially central section of the back surface and a second end extending to the left side of the substrate. The coplanar line 24D has a first end arranged in the substantially central section of the back surface and a second end extending to the right side of the substrate. The coplanar lines 24A to 24D correspond to back-surface lines according to preferred embodiments of the present invention, and their first ends function as a back-surface component mounting electrode 22 to be connected to an output terminal of an electronic component.

The front-surface earth electrode 15 extends over substantially the entire front surface of the substrate other than the coplanar lines 14A to 14D and their both sides. The back-surface earth electrode 25 extends over substantially the entire back surface of the substrate other than the coplanar lines 24A to 24D and their both sides. The interlayer earth electrodes 3A and 3B are positioned at different interfaces of the dielectric an extend over substantially the entire surfaces of their respective interfaces. The front-surface earth 15, the interlayer earth electrode 3A, and the coplanar lines 14A to 14D form a coplanar transmission path at the front of the substrate 1 for use in measuring electric characteristics. The back-surface earth electrode 25, the interlayer earth electrode 3B, and the coplanar lines 24A to 24D form a coplanar transmission path at the back surface of the substrate 1 for use in measuring electric characteristics.

The pattern of the coplanar lines 14A to 14D and the front-surface earth electrode 15 and the pattern of the coplanar lines 24A to 24D and the back-surface earth electrode 25 exhibit substantially the same shape when viewed from the direction of the normal to the front surface (or the direction of the normal to the back surface). The via electrodes 7 extend along the coplanar lines 14A to 14D and 24A to 24D and provide continuity between the front-surface earth electrode 15 and the back-surface earth electrode 25. The via electrodes 7 are made of a common pattern at the front surface and the back surface. Thus the total number of the via electrodes 7 can be reduced in comparison with a case where two substrates for use in measuring electric characteristics are prepared, and a reduced cost of production can be achieved.

Figs. 3A and 3B are perspective views of the substrate 1 for use in measuring electric characteristics.

To measure electric characteristics of a first 4-port electronic component 30A having terminals being asymmetric about a line by the use of the substrate 1 for use in measuring electric characteristics, as illustrated in Fig. 3A, the first 4-port electronic component 30A is implemented on the front-surface component mounting electrode 12 (not illustrated). Four coaxial connectors 31 are attached to the right side and the left side of the substrate 1 for use in measuring electric characteristics. The coplanar lines 14A to 14D are connected to a measurement device with substantially central conductors of the coaxial connectors 31 disposed therebetween. The front-surface earth electrode 15 is connected to an earth with external conductors of the coaxial connectors 31 disposed therebetween.

To measure electric characteristics of a second 4-port electronic component 30B having terminals positioned as mirror images of those in the first 4-port electronic component 30A by the use of the substrate for use in measuring electric characteristics, as illustrated in Fig. 3B, the second 4-port electronic component 30B is implemented on the back-surface component mounting electrode 22 (not illustrated). The coaxial connectors 31 are attached to the right side and the left side of the substrate 1 for use in measuring electric characteristics such that they are inverted. The coplanar lines 24A to 24D are connected to a measurement device with substantially central conductors of the coaxial connectors 31 disposed therebetween. The back-surface earth electrode 25 is connected to an earth with external conductors of the coaxial connectors 31 disposed therebetween.

For the substrate 1 for use in measuring electric characteristics, the component mounting electrode 12 disposed at the front surface and the component mounting electrode 22 disposed at the back surface exhibit the substantially same pattern when viewed from the direction of the normal to the front surface (or the direction of the normal to the back surface). Accordingly, electric characteristics of two types of electronic components 30A and 30B having terminals positioned as mirror images can be measured by the single substrate 1 for use in measuring electric characteristics. Thus a reduced cost of production of substrates and a reduced number of items of inventory control of substrates can be achieved.

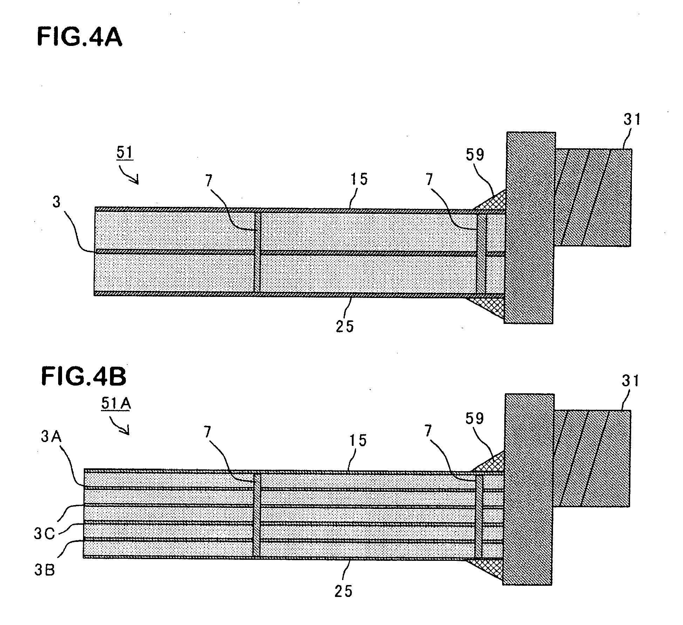

Next, configuration examples of a substrate for use in measuring electric characteristics according to a second embodiment of the present invention are described. Fig. 4A is a schematic side sectional view of a substrate 51 for use in measuring electric characteristics. The substrate 51 for use in measuring electric characteristics includes electrodes having substantially the same shape in plan view as that in the above-described substrate 1 for use in measuring electric characteristics. The substrate 51 for use in measuring electric characteristics is a laminated substrate in which two dielectric layers are laminated and includes the front-surface earth electrode 15, the back-surface earth electrode 25, and an interlayer earth electrode 3. Even with only one interlayer earth electrode, preferred embodiments of the present invention can be carried out. The coaxial connectors 31 and the substrate 51 for use in measuring electric characteristics are bonded by solder 59. However, any other means may be used in bonding the connectors and the substrate together.

Next, a modification example of the substrate for use in measuring electric characteristics according to the present embodiment is described. Fig. 4B is a schematic side sectional view of a substrate 51A for use in measuring electric characteristics. The substrate 51A for use in measuring electric characteristics is a laminated substrate in which five dielectric layers are laminated. In contrast to the above-described substrate 51 for use in measuring electric characteristics, the substrate 51A for use in measuring electric characteristics includes the interlayer earth electrode 3A facing the coplanar lines 14A to 14D and the interlayer earth electrode 3B facing the coplanar lines 24A to 24D. The interlayer earth electrodes 3A and 3B are positioned at different interfaces of the dielectric layers. The interlayer earth electrode 3A and the interlayer earth electrode 3B correspond to a first interlayer earth electrode and a second interlayer earth electrode, respectively, according to preferred embodiments of the present invention. The substrate 51A for use in measuring electric characteristics further includes interlayer earth electrodes 3C disposed between the interlayer earth electrodes 3A and 3B. With this configuration, the coplanar lines 14A to 14D and the coplanar lines 24A to 24D can be radio-frequency separated more reliably.

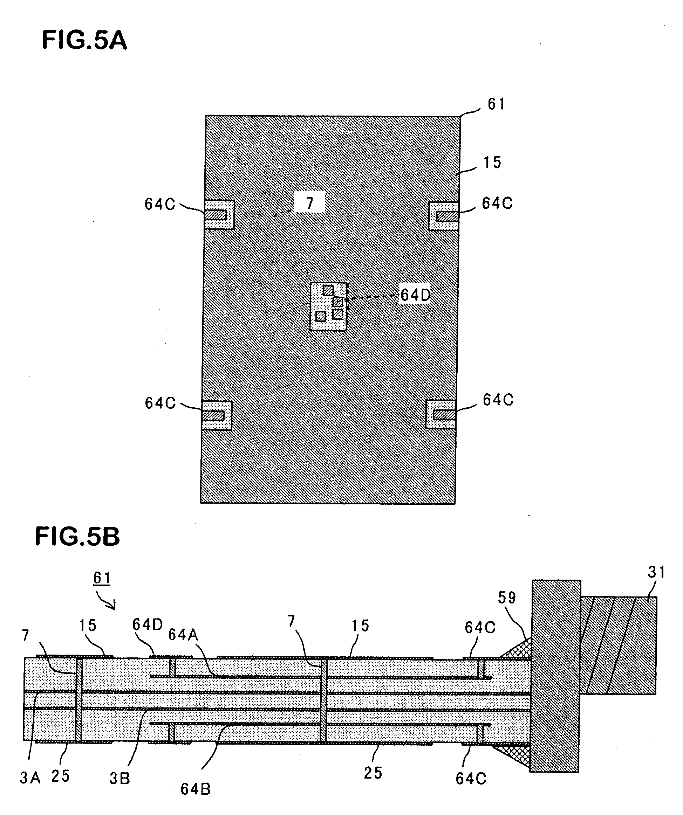

Next, a configuration example of a substrate for use in measuring electric characteristics according to a third embodiment of the present invention is described. Fig. 5A is a plan view of a substrate 61 for use in measuring electric characteristics. Fig. 5B is a schematic side sectional view of the substrate 61 for use in measuring electric characteristics.

The substrate 61 for use in measuring electric characteristics is a laminated substrate in which five dielectric layers are laminated and includes the front-surface earth electrode 15, the back-surface earth electrode 25, strip lines 64A and 64B, connector connecting electrodes 64C, component mounting electrodes 64D, and the interlayer earth electrodes 3A and 3B. The front-surface earth electrode 15 is disposed at the front surface. The strip line 64A is disposed between the dielectric layer of the front surface and the second dielectric layer. The interlayer earth electrode 3A is disposed between the second dielectric layer and the third dielectric layer. The interlayer earth electrode 3B is disposed between the third dielectric layer and the fourth dielectric layer. The strip line 64B is disposed between the fourth dielectric layer and the dielectric layer of the back surface. The back-surface earth electrode 25 is disposed at the back surface. The opposite ends of the strip line 64A are connected to the component mounting electrodes 64D and the connector connecting electrodes 64C disposed at the front surface with the via electrodes disposed therebetween. The opposite ends of the strip line 64B are connected to the component mounting electrodes 64D and the connector connecting electrodes 64C disposed at the back surface with the via electrodes disposed therebetween.

With this configuration, the component mounting electrodes 64D disposed at the front surface and at the back surface exhibit substantially the same pattern when viewed from the direction of the normal to the front surface (or the direction of the normal to the back surface). Thus electric characteristics of two types of electronic components having terminals positioned as mirror images can be measured by the substrate 61 for use in measuring electric characteristics. Accordingly, a reduced cost of production of substrates and a reduced number of items of inventory control of substrates can be achieved.

The strip line 64A and the strip line 64B exhibit substantially the same line pattern when viewed from the direction of the normal to the front surface (or the direction of the normal to the back surface). Therefore, the provision of the via electrodes 7 disposed along the strip lines 64A and 64B and passing through the substrate can achieve a reduced total number of the via electrode 7.

Next, configuration of a substrate for use in measuring electric characteristics according to other embodiments of the present invention are described.

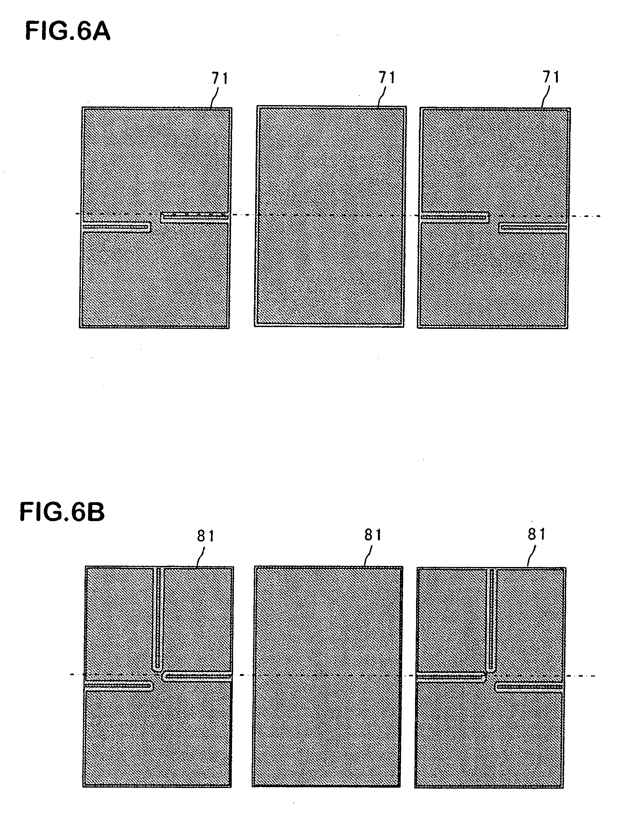

Fig. 6A is an exploded view of a substrate 71 for use in measuring electric characteristics and illustrates a front surface in the left, an interlayer of dielectric layers in the middle, and a back surface in the right.

The substrate 71 for use in measuring electric characteristics is a 2-port configuration. For electronic components having electric characteristics to be measured by the substrate 71 for use in measuring electric characteristics, it may be preferable that each of them includes two output terminals and there be a plurality of types of electronic components having terminals positioned as mirror images.

Fig. 6B is an exploded view of a substrate 81 for use in measuring electric characteristics and illustrates a front surface in the left, an interlayer of dielectric layers in the middle, and a back surface in the right.

The substrate 81 for use in measuring electric characteristics is a 3-port configuration. For electronic components having electric characteristics to be measured by the substrate 81 for use in measuring electric characteristics, it may be preferable that each of them includes three output terminals and there be a plurality of types of electronic components having terminals positioned as mirror images.

As illustrated above, the substrate for use in measuring electric characteristics according to preferred embodiments of the present invention can be carried out as long as it includes a line pattern asymmetric about a substantially central line of a front surface and a back surface of the substrate and supports a plurality of ports.

While preferred embodiments of the invention have been described above, it is to be understood that variations and modifications will be apparent to those skilled in the art without from the scope of the invention as defined by the following claims.

## Claims

1. A substrate (1) for use in measuring electric characteristics, the substrate comprising:
a plurality of dielectric layers laminated therein;
a front-surface component mounting electrode (12) disposed at a front surface of the substrate and allowing a first electronic component to be implemented thereon, the front-surface component mounting electrode (12) comprising a plurality of connections for connecting to terminals of said first electronic component; and
first connecting lines (14A-D) electrically connected at one end thereof to said front-surface component mounting electrode (12) and configured for connection at the other end thereof to a measuring device;
**characterized in that** the substrate further comprises:
a back-surface component mounting electrode (22) disposed at a back surface of the substrate and allowing a second electronic component to be implemented thereon, the back-surface component mounting electrode (22) comprising a plurality of connections for connecting to terminals of said second electronic component; and
second connecting lines (24A-D) electrically connected at one end thereof to said back-surface component mounting electrode (22) and configured for connection at the other end thereof to a measuring device;
wherein the front-surface component mounting electrode (12) and the back-surface component mounting electrode (22) exhibit a substantially same pattern when viewed from a direction of a normal to the front surface of the substrate,
the layout of the connections of the front-surface component mounting electrode (12) is asymmetric with respect to a line in the plane of the front surface and extending across the front surface substantially centrally thereof, and
the layout of the connections of the back-surface component mounting electrode (22) is asymmetric with respect to a line in the plane of the back surface and extending across the back surface substantially centrally thereof.

2. The substrate (1) for use in measuring electric characteristics according to Claim 1, further comprising:
at least one interlayer earth electrode (3A,3B) disposed between the dielectric layers of the substrate;
a plurality of front-surface lines (14A-D) being nearer to the front surface of the substrate than to the at least one interlayer earth electrode (3A) and being connected to the front-surface component mounting electrode (12); and
a plurality of back-surface lines (24A-D) being nearer to the back surface of the substrate than to the at least one interlayer earth electrode (3B) and being connected to the back-surface component mounting electrode (22),
wherein the plurality of front-surface lines (14A-D) and the plurality of back-surface lines (24A-D) exhibit a substantially same pattern when viewed from the direction of the normal to the front surface of the substrate.

3. The substrate (51A) for use in measuring electric characteristics according to Claim 2, wherein the at least one interlayer earth electrode comprises a first interlayer earth electrode (3A) facing the plurality of front-surface lines (14A-D) and a second interlayer earth electrode (3B) facing the plurality of back-surface lines (24A-D), and
the first interlayer earth electrode (3A) and the second interlayer earth electrode (3B) are positioned at different interfaces of the dielectric layers.

4. The substrate (51A) for use in measuring electric characteristics according to Claim 3, further comprising:
another interlayer earth electrode (3C) disposed between the first interlayer earth electrode (3A) and the second interlayer earth electrode (3B).

5. The substrate (1) for use in measuring electric characteristics according to any one of Claims 2 to 4, wherein the plurality of front-surface lines (14A-D) is disposed at the front surface of the substrate, and the plurality of back-surface lines (24A-D) is disposed at the back surface of the substrate,
the substrate further comprising:
a surface earth electrode (15,25) disposed beside each of the plurality of front-surface lines (14A-D) and the plurality of back-surface lines (24A-D); and
a via electrode (7) that provides continuity between the surface earth electrode (15,25) and the at least one interlayer earth electrode (3A,3B).

## Patentansprüche

1. Substrat (1) zur Verwendung bei der Messung elektrischer Eigenschaften, wobei das Substrat umfasst:
eine Mehrzahl von dielektrischen Lagen, welche darin laminiert sind,
eine Vorderseitenelektrode (12) zur Komponentenbefestigung, welche auf einer Vorderseite des Substrats angeordnet ist und erlaubt, eine erste elektronische Komponente daran zu implementieren, wobei die Vorderseitenelektrode (12) zur Komponentenbefestigung eine Mehrzahl von Verbindungen zum Verbinden mit Anschlüssen der ersten elektronischen Komponente umfasst, und
erste Verbindungsleitungen (14A-D), welche elektrisch mit einem ihrer Enden mit der Vorderflächenelektrode (12) zur Komponentenbefestigung verbunden sind und an ihrem anderen Ende zum Verbinden mit einer Messvorrichtung konfiguriert sind,
**dadurch gekennzeichnet, dass** das Substrat ferner umfasst:
eine Rückseitenelektrode (22) zur Komponentenbefestigung, welche an einer Rückseite des Substrats angeordnet ist und erlaubt, eine zweite elektronische Komponente daran zu implementieren, wobei die Rückseitenelektrode (22) zur Komponentenbefestigung eine Mehrzahl von Verbindungen zum Verbinden mit Anschlüssen der zweiten elektronischen Komponente umfasst, und
zweite Verbindungsleitungen (24A-D), welche elektrisch mit einem ihrer Enden mit der Rückseitenelektrode (22) zur Komponentenbefestigung verbunden sind und an ihrem anderen Ende zum Verbinden mit einer Messvorrichtung konfiguriert sind,
wobei die Vorderseitenelektrode (12) zur Komponentenbefestigung und die Rückseitenelektrode (22) zur Komponentenbefestigung ein im Wesentlichen gleiches Muster zeigen, wenn von einer Richtung einer Normalen zur Vorderseite des Substrats aus betrachtet,
wobei das Layout der Verbindungen der Vorderseitenelektrode (12) zur Komponentenbefestigung asymmetrisch in Bezug auf eine Linie in der Ebene der Vorderseite ist und sich quer über die Vorderseite im Wesentlichen zentral davon erstreckt, und
wobei das Layout der Verbindungen der Rückseitenelektrode (22) zur Komponentenbefestigung asymmetrisch in Bezug auf eine Linie in der Ebene der Rückseite liegt und sich quer über die Rückseite im Wesentlichen zentral davon erstreckt.

2. Substrat (1) zur Verwendung bei der Messung elektrischer Eigenschaften nach Anspruch 1, ferner umfassend:
wenigstens eine Zwischenlagenmasseelektrode (3A, 3B), welche zwischen den dielektrischen Lagen des Substrats angeordnet ist,
eine Mehrzahl der Vorderseitenleitungen (14A-D), welche näher der Vorderseite des Substrats sind als zur wenigstens einen Zwischenlagenmasseelektrode (3A) und welche mit der Vorderseitenelektrode (12) zur Komponentenbefestigung verbunden sind, und
eine Mehrzahl der Rückseitenleitungen (24A-D), welche näher der Rückseite des Substrats sind als zur wenigstens einen Zwischenlagenmasseelektrode (3B) und welche mit der Rückseitenelektrode (22) zur Komponentenbefestigung verbunden sind,
wobei die Mehrzahl der Vorderseitenleitungen (14A-D) und die Mehrzahl der Rückseitenleitungen (24A-D) ein im Wesentlichen gleiches Muster zeigen, wenn von einer Richtung einer Normalen zur Vorderseite des Substrats aus betrachtet.

3. Substrat (51A) zur Verwendung bei der Messung elektrischer Eigenschaften nach Anspruch 2, wobei die wenigstens eine Zwischenlagenmasseelektrode eine erste Zwischenlagenmasseelektrode (3A), welche der Mehrzahl der Vorderseitenleitungen (14A-D) zugewandt ist, und eine zweite Zwischenlagenmasseelektrode (3B) umfasst, welche der Mehrzahl der Rückseitenleitungen (24A-D) zugewandt ist, und
wobei die eine erste Zwischenlagenmasseelektrode (3A) und die zweite Zwischenlagenmasseelektrode (3B) an unterschiedlichen Schnittstellen der dielektrischen Lagen positioniert sind.

4. Substrat (51 A) zur Verwendung bei der Messung elektrischer Eigenschaften nach Anspruch 3, ferner umfassend:
eine weitere Zwischenlagenmasseelektrode (3C), welche zwischen der ersten Zwischenlagenmasseelektrode (3A) und der zweiten Zwischenlagenmasseelektrode (3B) angeordnet ist.

5. Substrat (1) zur Verwendung bei der Messung elektrischer Eigenschaften nach einem beliebigen der Ansprüche 2 bis 4, wobei die Mehrzahl der Vorderseitenleitungen (14A-D) an der Vorderseite des Substrats angeordnet ist und die Mehrzahl der Rückseitenleitungen (24A-D) an der Rückseite des Substrats angeordnet ist,
wobei das Substrat ferner umfasst:
eine Oberflächenmasseelektrode (15, 25), welche neben jeder der Mehrzahl der Vorderseitenleitungen (14A-D) und der Mehrzahl der Rückseitenleitungen (24A-D) angeordnet ist, und
eine Durchkontaktierungselektrode (7), welche ununterbrochenen Zusammenhang zwischen der Oberflächenmasseelektrode (15, 25) und der wenigstens einen Zwischenlagenmasseelektrode (3A, 3B) bereitstellt.

## Revendications

1. Substrat (1) à utiliser pour la mesure de caractéristiques électriques, le substrat comprenant :
une pluralité de couches diélectriques stratifiées dans celui-ci ;
une électrode de surface avant pour montage de composant (12) disposée au niveau d'une surface avant du substrat et permettant la mise en oeuvre d'un premier composant électronique sur celui-ci, l'électrode de surface avant pour montage de composant (12) comprenant une pluralité de connexions pour la connexion à des bornes dudit premier composant électronique ; et
des premières lignes de connexion (14A-D) connectées électriquement à l'une de leurs extrémités à ladite électrode de surface avant pour montage de composant (12) et configurées pour la connexion à leur autre extrémité à un dispositif de mesure ;
**caractérisé en ce que** le substrat comprend en outre :
une électrode de surface arrière pour montage de composant (22) disposée sur une surface arrière du substrat et permettant la mise en oeuvre d'un deuxième composant électronique sur celui-ci, l'électrode de surface arrière pour montage de composant (22) comprenant une pluralité de connexions pour la connexion à des bornes dudit deuxième composant électronique ; et
des deuxièmes lignes de connexion (24A-D) connectées électriquement à l'une de leurs extrémités à ladite électrode de surface arrière pour montage de composant (22) et configurées pour la connexion à leur autre extrémité à un dispositif de mesure ;
dans lequel l'électrode de surface avant pour montage de composant (12) et l'électrode de surface arrière pour montage de composant (22) ont un motif essentiellement identique lorsqu'on le regarde selon une direction normale à la surface avant du substrat,
l'implantation des connexions de l'électrode avant de type composant monté en surface (12) est asymétrique par rapport à une ligne située dans le plan de la surface avant et s'étendant à travers la surface avant en une position essentiellement centrale de celle-ci, et
l'implantation des connexions de l'électrode de surface arrière pour montage de composant (22) est asymétrique par rapport à une ligne située dans le plan de la surface arrière et s'étendant à travers la surface arrière en une position essentiellement centrale de celle-ci.

2. Substrat (1) à utiliser pour la mesure de caractéristiques électriques selon la revendication 1, comprenant en outre :
au moins une électrode de terre de couche intermédiaire (3A, 3B) disposée entre les couches diélectriques du substrat ;
une pluralité de lignes de surface avant (14A-D) située plus près de la surface avant du substrat que de l'au moins une électrode de terre de couche intermédiaire (3A) et connectée à l'électrode de surface avant pour montage de composant (12); et
une pluralité de lignes de surface arrière (24A-D) située plus près de la surface arrière du substrat que de l'au moins une électrode de terre de couche intermédiaire (3B) et connectée à l'électrode de surface arrière pour montage de composant (22),
dans lequel la pluralité de lignes de surface avant (14A-D) et la pluralité de lignes de surface arrière (24A-D) ont un motif essentiellement identique lorsqu'on le regarde selon une direction normale à la surface avant du substrat.

3. Substrat (51A) à utiliser pour la mesure de caractéristiques électriques selon la revendication 2, dans lequel l'au moins une électrode de terre de couche intermédiaire comprend une première électrode de terre de couche intermédiaire (3A) en regard de la pluralité de lignes de surface avant (14A-D) et une deuxième électrode de terre de couche intermédiaire (3B) en regard de la pluralité de lignes de surface arrière (24A-D), et
la première électrode de terre de couche intermédiaire (3A) et la deuxième électrode de terre de couche intermédiaire (3B) sont positionnées à différentes interfaces des couches diélectriques.

4. Substrat (51A) à utiliser pour la mesure de caractéristiques électriques selon la revendication 3, comprenant en outre :
une autre électrode de terre de couche intermédiaire (3C) disposée entre la première électrode de terre de couche intermédiaire (3A) et la deuxième électrode de terre de couche intermédiaire (3B).

5. Substrat (1) à utiliser pour la mesure de caractéristiques électriques selon l'une quelconque des revendications 2 à 4, dans lequel la pluralité de lignes de surface avant (14A-D) est disposée au niveau de la surface avant du substrat, et la pluralité de lignes de surface arrière (24A-D) est disposée au niveau de la surface arrière du substrat,
le substrat comprenant en outre :
une électrode de terre de surface (15, 25) disposée à côté de chacune de la pluralité de lignes de surface avant (14A-D) et de la pluralité de lignes de surface arrière (24A-D) ; et
une électrode traversante (7) qui réalise une continuité entre l'électrode de terre de surface (15, 25) et l'au moins une électrode de terre de couche intermédiaire (3A, 3B).
